# EUROPEAN PATENT SPECIFICATION

(11) **EP 2 840 875 B1**
(45) Date of publication and mention of the grant of the patent: **12.05.2021**
(21) Application number: 14781800.9
(22) Date of filing: 12.03.2014
(51) Int. Cl.: H05K 7/20

(54) **LIQUID-COOLED RADIATOR**
FLÜSSIGKEITSGEKÜHLTER HEIZKÖRPER
RADIATEUR À REFROIDISSEMENT LIQUIDE

(30) Priority: 19.06.2013 CN 201310244119
(43) Date of publication of application: 25.02.2015
(73) Proprietor: Huawei Technologies Co., Ltd., Longgang District Shenzhen, Guangdong 518129 (CN)
(72) Inventor: WANG, Chao, Shenzhen Guangdong 518129 (CN); LI, Quanming, Shenzhen Guangdong 518129 (CN); LIU, Xiaohu, Shenzhen Guangdong 518129 (CN)
(74) Representative: Gill Jennings & Every LLP
(86) International application number: PCT/CN2014/073264
(87) International publication number: WO 2014/201880

(56) References cited:
- WO-A1-2012/171054
- CN-A- 103 327 795
- CN-U- 202 816 913
- CN-Y- 2 930 222
- US-A1- 2006 096 742
- US-A1- 2006 108 100
- US-A1- 2006 231 236
- US-A1- 2011 067 841
- US-B2- 6 867 973
- US-B2- 6 867 973

## Description

### TECHNICAL FIELD

The present invention relates to a cold plate, and in particular, to a liquid cooling cold plate.

### BACKGROUND

With a continuous increase in heating power of high-performance CPUs and electrical and electronic devices, a liquid cooling technology has been used as a heat dissipation solution for more devices, such as a supercomputer, a data server, a general inverter, and a wind energy converter.

Currently, the liquid cooling technology is widely used for heat dissipation in automobile, high-speed railway, and wind power generation industries and the like, and liquid cooling devices are also used in various fields, such as telecommunication, server, energy, and automobile fields. As a critical heat-dissipation component, a liquid cooling cold plate plays a more important role.

Different from a traditional air cooling radiator, the liquid cooling cold plate uses a cooling liquid, such as water, as a cooling medium, and it has compact structure and high heat-dissipation efficiency and is commonly used when heat flux density is high.

However, in an existing liquid cooling cold plate, formed turbulent flows are insufficient while the cooling liquid flows, and heat is dissipated only by simply flowing in a flow channel, which cannot fully achieve a heat-dissipation effect of the liquid cooling technology. US6867973, US2006/108100, US2006/231236, WO2012/171054, and US2011/067841 each disclose cooling cold plates with liquid flow channels.

In particular, US2011/067841 provides a heat sink that eliminates inefficient coolant bypass channels. The heat sink comprises a coolant cavity that is defined by a cover and a body portion. The thermally conductive cover includes a first plurality of substantially uniformly dispersed pin fins that extend at an angle from the inside surface of the cover towards a section of the body portion that is opposite the cover. The body portion opposite the cover includes a second plurality of pin fins that extend in the opposite direction from the first plurality. The coolant cavity also includes thermal bosses that protrude from an inside surface of the body portion. The bosses run parallel to the first and second plurality of pin fins and extend from a point near the thermally conductive cover to the section of the thermally conductive body portion that is opposite to the thermally conductive cover.

### SUMMARY

A technical problem to be solved by aspects of the present invention is the problem of an insufficient cooling effect in the prior art.

In particular, the present invention provides a liquid cooling cold plate according to claim 1. Further technical features are defined in the dependent claims.

In the liquid cooling cold plate according to the aspects of the present invention, the protrusions arranged in the staggered manner are disposed in the flow channel, so that turbulent flows are generated in each direction when a cooling liquid flows through the flow channel, thereby strengthening a heat transfer effect.

### BRIEF DESCRIPTION OF DRAWINGS

To describe the technical solutions in the aspects of the present invention more clearly, the following briefly introduces the accompanying drawings required for describing the aspects. Apparently, the accompanying drawings in the following description show merely some aspects of the present invention, and a person of ordinary skill in the art may still derive other drawings from these accompanying drawings without creative efforts.
FIG. 1 is a schematic diagram of a liquid cooling cold plate according to a first aspect of the present invention;
FIG. 2 is a schematic diagram of an upper substrate of the liquid cooling cold plate in FIG. 1;
FIG. 3 is a schematic diagram of a lower substrate of the liquid cooling cold plate in FIG. 1;
FIG. 4 is a schematic diagram of a principle of the liquid cooling cold plate in FIG. 1;
FIG. 5 is a schematic diagram showing an arrangement of protrusions of a liquid cooling cold plate according to a second aspect of the present invention;
FIG. 6 is a schematic diagram showing an arrangement of protrusions of a liquid cooling cold plate according to a third aspect of the present invention;
FIG. 7 is a schematic diagram showing an arrangement of protrusions of a liquid cooling cold plate according to a fourth aspect of the present invention;
FIG. 8 is a schematic diagram showing an arrangement of protrusions of a liquid cooling cold plate according to a fifth aspect of the present invention;
FIG. 9 is a schematic diagram showing an arrangement of protrusions of a liquid cooling cold plate according to a sixth aspect of the present invention;
FIG. 10 is a schematic diagram showing an arrangement of protrusions of a liquid cooling cold plate according to a seventh aspect of the present invention;
FIG. 11 is a schematic diagram showing an arrangement of protrusions of a liquid cooling cold plate according to an eighth aspect of the present invention; and
FIG. 12 is a schematic diagram of a principle of a liquid cooling cold plate according to a ninth aspect of the present invention.

### DESCRIPTION OF ASPECTS

The following clearly describes the technical solutions in the aspects of the present invention with reference to the accompanying drawings in the aspects of the present invention. Apparently, the described aspects are merely a part rather than all of the aspects of the present invention, the protection scope of the present invention being defined by the appended claims.

In the aspects of the present invention, protrusions arranged in a staggered manner are disposed in a flow channel, so that turbulent flows are generated in each direction when a cooling liquid flows through the flow channel, thereby strengthening a heat transfer effect.

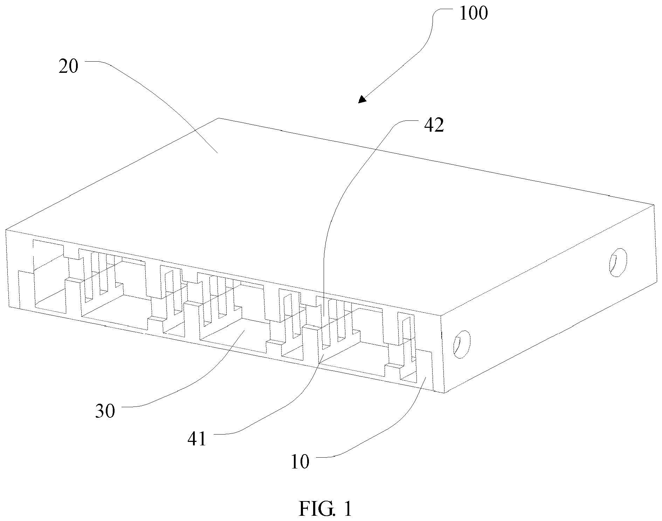

Referring to FIG. 1, a first aspect of the present invention provides a liquid cooling cold plate 100. The liquid cooling cold plate 100 includes an upper substrate 10, a lower substrate 20, a flow channel 30, and two layers of turbulent flow components 41 and 42. The upper substrate 10 and the lower substrate 20 are mutually clamped, the flow channel 30 is formed between the upper substrate 10 and the lower substrate 20, and the two layers of turbulent flow components 41 and 42 are stacked in the flow channel 30. Certainly, in other aspects, the flow channel 30 may also be formed in an enclosed case. The liquid cooling cold plate 100 may also include multiple layers of the turbulent flow components.

The flow channel 30 is an S-shaped flow channel. Specifically, the flow channel 30 is formed by cascading S shapes, and a cross section of the flow channel 30 is a rectangle. Certainly, in other aspects, the flow channel 30 may also be in a maze shape or be formed by multiple sub-flow channels connected in parallel. A cross section of the flow channel 30 may also be in another shape, such as a circle or a rhombus.

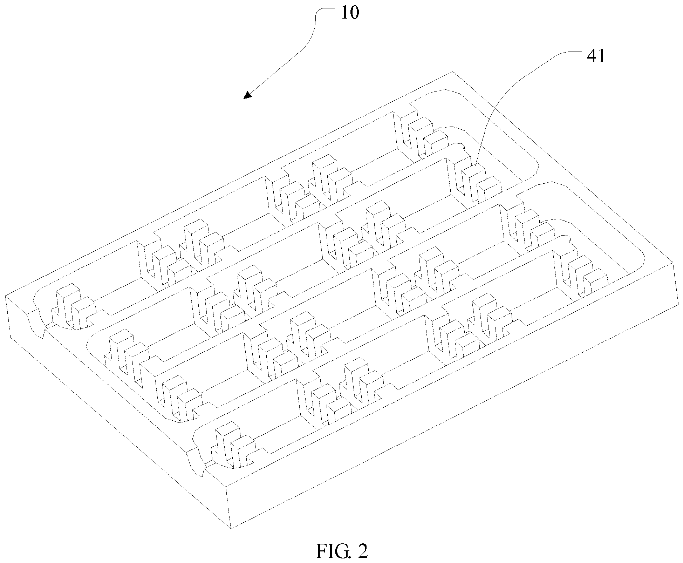

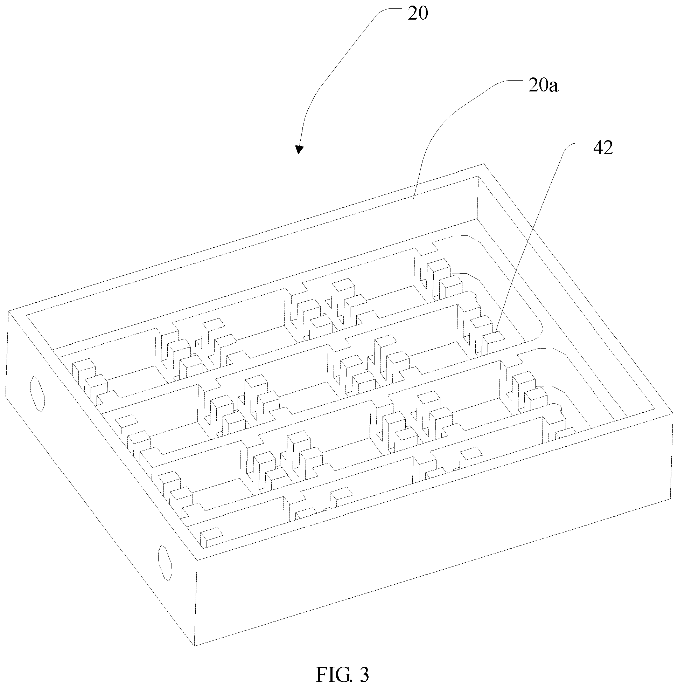

Referring to FIG. 2 to FIG. 4 together, the upper substrate 10 is a rectangle plate-type structure. An upper half part of the flow channel 30 is arranged and one layer of the turbulent flow component 41 is formed on one side of the upper substrate 10. In this implementation manner, the upper substrate 10 is manufactured by using copper. Certainly, in other aspects, the upper substrate 10 may also be manufactured by using aluminum or other metal, or manufactured by using another non-metallic material that easily conducts heat. The upper substrate 10 may also be in another shape, such as a half-cylinder or a prism.

The lower substrate 20 is a rectangle plate-type structure, and has a flange 20a formed on the periphery of the lower substrate 20 for receiving the upper substrate 10. A lower half part of the flow channel 30 is arranged and the turbulent flow component 42 adjacent to the turbulent flow component 41 is formed on one side of the lower substrate 20. In this implementation manner, the lower substrate 20 is manufactured by using copper. Certainly, in other aspects, the lower substrate 20 may also be manufactured by using aluminum or other metal, or manufactured by using another non-metallic material that easily conducts heat. The lower substrate 20 may also be in another shape, such as a half-cylinder or a prism. The lower substrate 20 and the upper substrate 10 are welded together in a manner such as a friction stir welding or soldering and brazing manner, so as to avoid leakage.

The two layers of the turbulent flow components 41 and 42 include multiple protrusions 41a and 42a arranged in multiple columns, each column of protrusions 41a and 42a at one layer and a corresponding column of protrusions 41a and 42a at an adjacent layer are oppositely disposed in a one-to-one manner, and the protrusions 41a at one layer and the corresponding protrusions 42a at the adjacent layer are arranged in a staggered manner. In this implementation manner, end faces of the protrusions 41a in each column at one layer are level with end faces of the protrusions 42a in a corresponding column at the adjacent layer. A width of a protrusion 41a in each column at one layer is the same as a width of a corresponding protrusion 42a in each column at the adjacent layer. Each protrusion 41a is directly opposite to a distance between the protrusions 42a, and the protrusion 42a is directly opposite to a distance between the protrusions 41a. The end faces of the protrusions 41a are on the same plane as the end faces of the protrusions 42a. Certainly, in other aspects, an interval may also exist between each column of protrusions 41a at one layer and the corresponding column of protrusions 42a at the adjacent layer, and the protrusions 41a at one layer may also intersect with the corresponding protrusions 42a at the adjacent layer, that is, they partially overlap. A width of a protrusion 41a at one layer may also be greater than or less than a width of a corresponding protrusion 42a at the adjacent layer.

The protrusions 41a are directly formed on the upper substrate 10 in a groove milling manner. A distance d1 exists between the columns of protrusions 41a, so that there is sufficient space to form a turbulent flow after a cooling liquid flows through the protrusions 41a, which improves a heat transfer effect. A cross section of the protrusions 41a is a rectangle.

Certainly, in other aspects, the distance between the columns of protrusions 41a may also be zero, and the cross section of the protrusions 41a may also be a trapezoid or a triangle. The protrusions 41a may further be formed in the flow channel 30 in a die-casting, welding or relieving manner, that is, the protrusions 41a are formed on the upper substrate 10 in the die-casting, welding or relieving manner.

A sub-flow channel 41b is formed between the protrusions 41a, and a direction to which the sub-flow channel 41b is extended is parallel with or makes an included angle with a direction of the flow channel 30. In this implementation manner, the direction to which the sub-flow channel 41b is extended is parallel with the direction of the flow channel 30. Each of the protrusions 41a is parallel with an inner wall of the flow channel 30.

In this implementation manner, the protrusions 42a are directly formed on the lower substrate 20 in a groove milling manner. A distance d2 exists between the columns of the protrusions 42a, so that there is sufficient space to form a turbulent flow after the cooling liquid flows through the protrusions 42a, which improves the heat transfer effect. A cross section of the protrusions 42a is a rectangle.

Certainly, in other aspects, the distance between the columns of the protrusions 42a may also be zero, and the cross section of the protrusions 42a may also be a trapezoid or a triangle. The protrusions 42a may be formed in the flow channel 30 in a die-casting, welding or relieving manner, that is, the protrusions 42a are formed on the upper substrate 20 in the die-casting, welding or relieving manner.

A sub-flow channel 42b is formed between the protrusions 42a, and a direction to which the sub-flow channel 42b is extended is parallel with or makes an included angle with a direction of the flow channel 30. In this implementation manner, the direction to which the sub-flow channel 42b is extended is parallel with the direction of the flow channel 30. Each of the protrusions 42a is parallel with an inner wall of the flow channel 30.

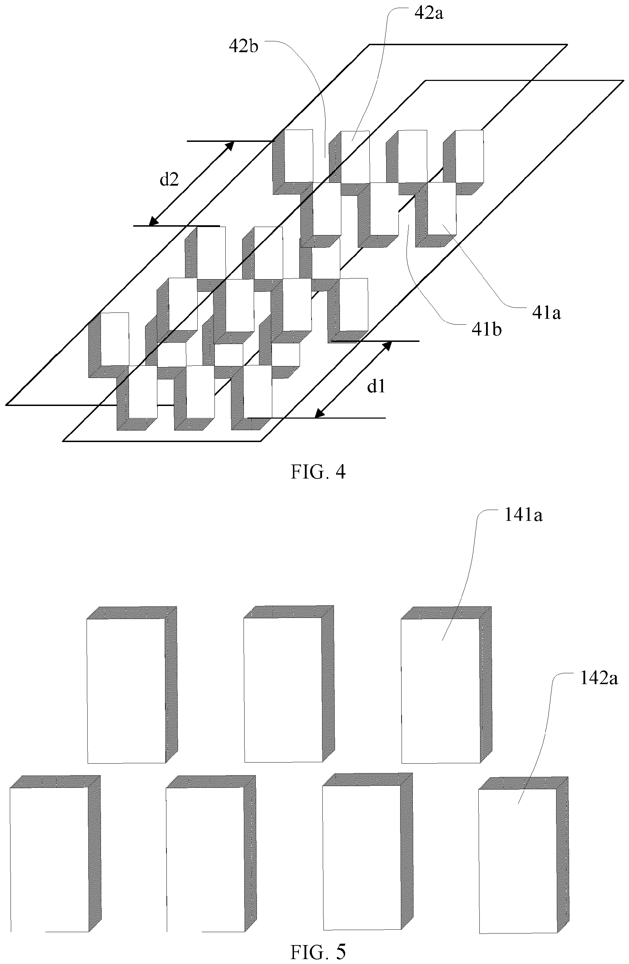

Referring to FIG. 5, a second aspect of the present invention provides a liquid cooling cold plate. The liquid cooling cold plate is basically the same as the liquid cooling cold plate 100 according to the first aspect, and a difference between them is that an interval exists between each column of protrusions 141a at one layer and a corresponding column of protrusions 142a at an adjacent layer.

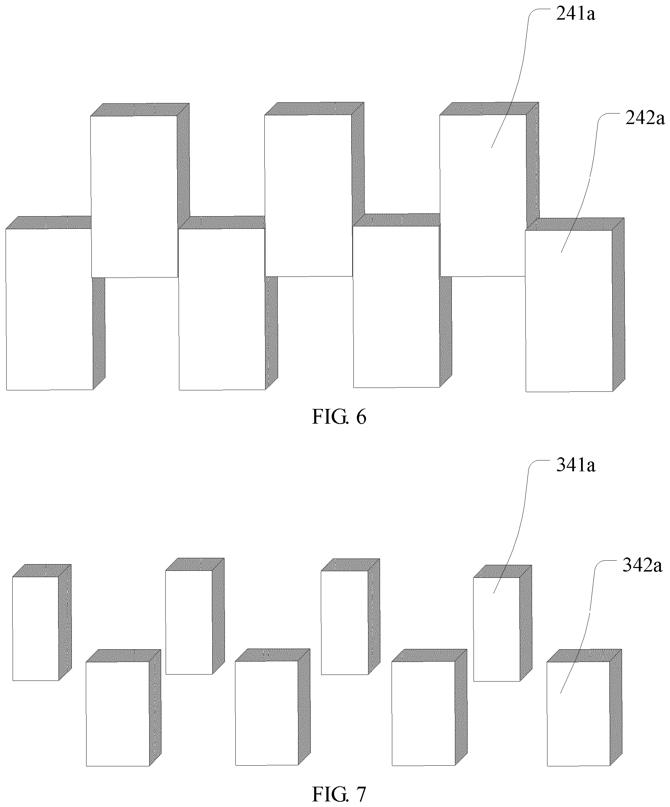

Referring to FIG. 6, a third aspect of the present invention provides a liquid cooling cold plate. The liquid cooling cold plate is basically the same as the liquid cooling cold plate 100 according to the first aspect, and a difference between them is that protrusions 241a at one layer intersect with corresponding protrusions 242a at an adjacent layer.

Referring to FIG. 7, a fourth aspect of the present invention provides a liquid cooling cold plate. The liquid cooling cold plate is basically the same as the liquid cooling cold plate 100 according to the first aspect, and a difference between them is that a width of a protrusion 341a at one layer is less than a width of a corresponding protrusion 342a at an adjacent layer.

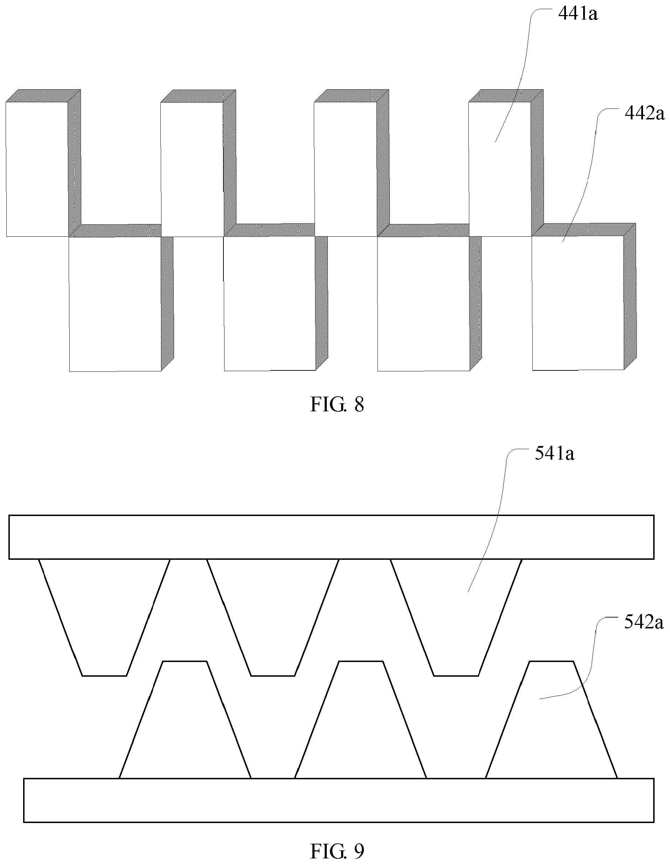

Referring to FIG. 8, a fifth aspect of the present invention provides a liquid cooling cold plate. The liquid cooling cold plate is basically the same as the liquid cooling cold plate according to the fourth aspect, and a difference between them is that a width of a protrusion 441a at one layer is equal to a distance between corresponding protrusions 442a at an adjacent layer.

Referring to FIG. 9, a sixth aspect of the present invention provides a liquid cooling cold plate. The liquid cooling cold plate is basically the same as the liquid cooling cold plate 100 according to the first aspect, and differences between them are that cross sections of protrusions 541a and 542a in each column at two adjacent layers of the liquid cooling cold plate are all trapezoids, and the protrusions 541a and 542a intersect without a contact.

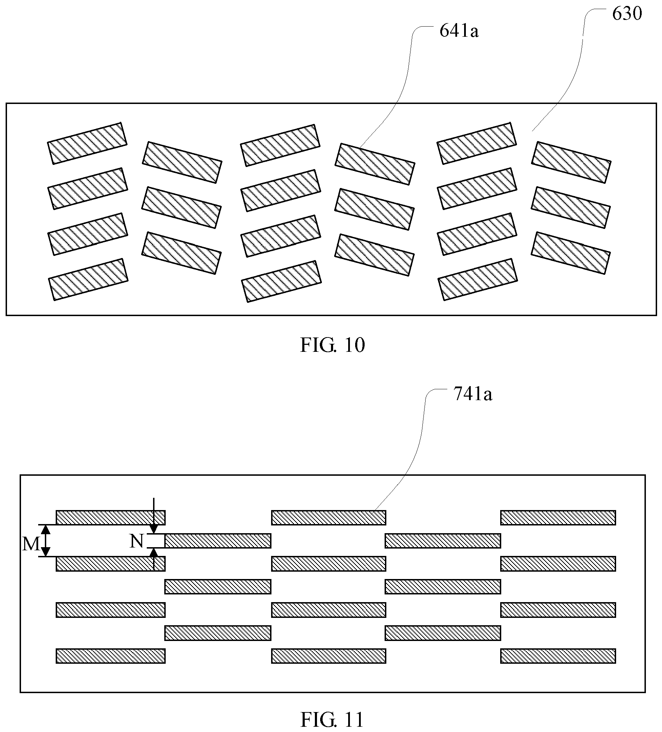

Referring to FIG. 10, a seventh aspect of the present invention provides a liquid cooling cold plate. The liquid cooling cold plate is basically the same as the liquid cooling cold plate 100 according to the first aspect, and a difference between them is that a direction to which a sub-flow channel 641b is extended makes an included angle with a direction of a flow channel 630.

Referring to FIG. 11, an eighth aspect of the present invention provides a liquid cooling cold plate. The liquid cooling cold plate is basically the same as the liquid cooling cold plate 100 according to the first aspect, and differences between them are that a distance M between protrusions 741a in one column is greater than a width N of corresponding protrusions 741a in an adjacent column, and a distance between the columns of the protrusions 741a is zero.

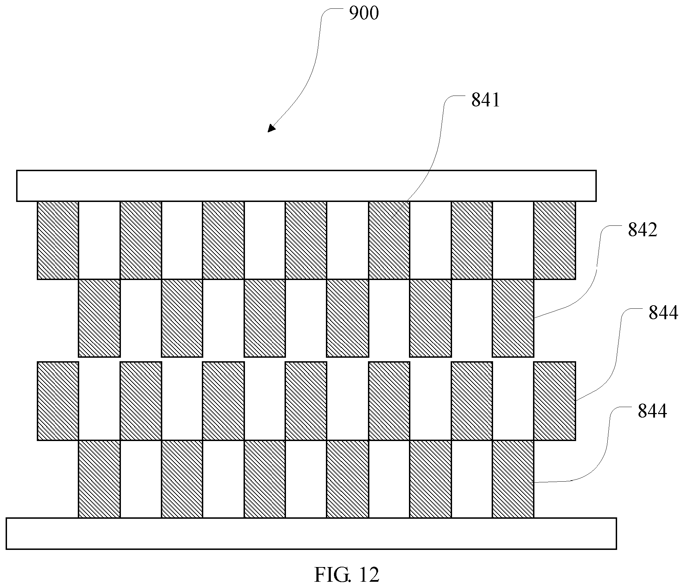

Referring to FIG. 12, a ninth aspect of the present invention provides a liquid cooling cold plate 900. The liquid cooling cold plate 900 is basically the same as the liquid cooling cold plate 100 according to the first aspect, and a difference between them is that the liquid cooling cold plate 900 includes four layers of turbulent flow components 841, 842, 843, and 844.

In the liquid cooling cold plates according to the aspects of the present invention, the protrusions arranged in the staggered manner are disposed in the flow channel, so that turbulent flows are generated in each direction when a cooling liquid flows through the flow channel, thereby strengthening a heat transfer effect.

In addition, a system pressure loss may further be flexibly changed by changing sizes and lengths of the protrusions or distances between the protrusions in a case in which a heat-dissipation requirement is met.

In addition, because the protrusions may be directly formed by means of groove milling or die-casting, contact thermal resistance between the protrusions and upper and lower substrates may be reduced, thereby achieving a good heat-dissipation effect.

In addition, on the premise that the heat-dissipation effect is achieved, a wide flow channel is adopted as the sub-flow channel formed between the protrusions, which can reduce a flowing speed of the liquid in the flow channel and reduce impact of flowing of the cooling liquid on the liquid cooling cold plate.

In addition, the system pressure loss decreases effectively after a decrease in the flowing speed; moreover, due to turbulence when the cooling liquid flows, thermal resistance of the cold plate is also obviously reduced.

The above merely discloses exemplary aspects of the present invention, which are not intended to limit claims of the present invention; therefore, equivalent changes made according to the claims of the present invention shall still fall within the scope of the present invention.

## Claims

1. A liquid cooling cold plate (100, 900), wherein the liquid cooling cold plate comprises a flow channel (30) and at least two layers of turbulent flow components (41, 42, 841, 842, 843, 844), wherein the at least two layers of turbulent flow components (41, 42, 841, 842, 843, 844) are stacked in the flow channel (30), each layer of the turbulent flow component comprises multiple protrusions (41a, 42a; 141a, 142a; 241a, 242a; 341a, 342a; 441a, 442a; 541a, 542a; 641a; 741a) arranged in multiple columns,
each column of protrusions at one layer and a corresponding column of protrusions at an adjacent layer are oppositely disposed in a one-to-one manner, and the protrusions at one layer and the corresponding protrusions at the adjacent layer are arranged in a staggered manner;
a sub-flow channel (42b) is formed between the protrusions in each column, and a direction to which the sub-flow channel (42b) is extended makes an included angle with a direction in which a cooling liquid flows through the flow channel (30);
wherein end faces of the protrusions (441a) in each column at one layer are level with end faces of the protrusions (442a) in the corresponding column at the adjacent layer; or wherein the protrusions (241a) at one layer intersect with the corresponding protrusions (242a) at the adjacent layer; and
wherein a width of a protrusion at one layer is equal to a distance between corresponding protrusions at the adjacent layer.

2. The liquid cooling cold plate (100, 900) according to claim 1, wherein a width of a protrusion (441a) in each column at one layer is the same as a width of a corresponding protrusion (442a) in each column at the adjacent layer.

3. The liquid cooling cold plate (100, 900) according to claim 1, wherein a width of a protrusion at one layer is greater than or less than a width of a corresponding protrusion at the adjacent layer.

4. The liquid cooling cold plate (100, 900) according to claim 1, wherein a cross section of each protrusion is a rectangle, a trapezoid, or a triangle.

5. The liquid cooling cold plate (100, 900) according to one of claims 1 to 4, wherein each protrusion is formed in the flow channel (30) by a processing method in a groove milling, die-casting, welding or relieving manner.

6. The liquid cooling cold plate (100, 900) according to one of claims 1 to 5, wherein a distance exists between the protrusions in each column.

7. The liquid cooling cold plate (100, 900) according to any one of claims 1 to 6, wherein the liquid cooling cold plate comprises an upper substrate (10) and a lower substrate (20), the upper substrate (10) and the lower substrate (20) are mutually clamped, the flow channel (30) is formed between the upper substrate (10) and the lower substrate (20), and the protrusions (41a, 42a; 141a, 142a; 241a, 242a; 341a, 342a; 441a, 442a; 541a, 542a; 641a; 741a) are disposed on the upper substrate (10) and the lower substrate (20).

## Patentansprüche

1. Flüssigkeitskühlungskühlplatte (100, 900), wobei die Flüssigkeitskühlungskühlplatte einen Strömungskanal (30) und mindestens zwei Lagen Turbulenzströmungskomponenten (41, 42, 841, 842, 843, 844) umfasst, wobei die mindestens zwei Lagen von Turbulenzströmungskomponenten (41, 42, 841, 842, 843, 844) in dem Strömungskanal (30) gestapelt sind, wobei jede Lage der Turbulenzströmungskomponenten mehrere Vorsprünge (41a, 42a; 141a, 142a; 241a, 242a; 341a, 342a; 441a, 442a; 541a, 542a; 641a; 741a) umfasst, die in mehreren Spalten angeordnet sind,
wobei jede Spalte von Vorsprüngen in einer Lage und eine entsprechende Spalte von Vorsprüngen in einer benachbarten Lage auf eine Weise von eins-zu-eins gegenüberliegend angeordnet sind und die Vorsprünge in einer Lage und die entsprechenden Vorsprünge in der benachbarten Lage auf eine versetzte Weise angeordnet sind;
ein Teilströmungskanal (42b) zwischen den Vorsprüngen in jeder Spalte ausgebildet ist und eine Richtung, in die sich der Teilströmungskanal (42b) erstreckt mit einer Richtung, in die eine Kühlflüssigkeit durch den Strömungskanal (30) strömt einen Winkel einschließt;
wobei sich Endflächen der Vorsprünge (441a) in jeder Spalte in einer Lage mit Endflächen der Vorsprünge (442a) in der entsprechenden Spalte in der benachbarten Lage auf gleicher Höhe befinden; oder wobei sich die Vorsprünge (241a) in einer Lage mit den entsprechenden Vorsprüngen (242a) in der benachbarten Lage schneiden; und
wobei eine Breite eines Vorsprungs in einer Lage gleich einem Abstand zwischen entsprechenden Vorsprüngen in der benachbarten Lage ist.

2. Flüssigkeitskühlungskühlplatte (100, 900) nach Anspruch 1, wobei eine Breite eines Vorsprungs (441a) in jeder Spalte in einer Lage gleich einer Breite eines entsprechenden Vorsprungs (442a) in jeder Spalte in der benachbarten Lage ist.

3. Flüssigkeitskühlungskühlplatte (100, 900) nach Anspruch 1, wobei eine Breite eines Vorsprungs in einer Lage größer als oder kleiner als eine Breite eines entsprechenden Vorsprungs in der benachbarten Lage ist.

4. Flüssigkeitskühlungskühlplatte (100, 900) nach Anspruch 1, wobei ein Querschnitt jedes Vorsprungs ein Rechteck, ein Trapez oder ein Dreieck ist.

5. Flüssigkeitskühlungskühlplatte (100, 900) nach einem der Ansprüche 1 bis 4, wobei jeder Vorsprung in dem Strömungskanal (30) durch ein Bearbeitungsverfahren durch Nutenfräsen, Druckgießen, Schweißen oder Aussparen gebildet ist.

6. Flüssigkeitskühlungskühlplatte (100, 900) nach einem der Ansprüche 1 bis 5, wobei zwischen den Vorsprüngen in jeder Spalte ein Abstand besteht.

7. Flüssigkeitskühlungskühlplatte (100, 900) nach einem der Ansprüche 1 bis 6, wobei die Flüssigkeitskühlungskühlplatte ein oberes Substrat (10) und ein unteres Substrat (20) umfasst, wobei das obere Substrat (10) und das untere Substrat (20) zusammengeklemmt sind, der Strömungskanal (30) zwischen dem oberen Substrat (10) und dem unteren Substrat (20) gebildet ist und die Vorsprünge (41a, 42a; 141a, 142a; 241a, 242a; 341a, 342a; 441a, 442a; 541a, 542a; 641a; 741a) auf dem oberen Substrat (10) und dem unteren Substrat (20) angeordnet sind.

## Revendications

1. Plaque froide à refroidissement liquide (100, 900), la plaque froide à refroidissement liquide comprenant un canal d'écoulement (30) et au moins deux couches de composants d'écoulement turbulent (41, 42, 841, 842, 843, 844), les au moins deux couches de composants d'écoulement turbulent (41, 42, 841, 842, 843, 844) étant empilées dans le canal d'écoulement (30), chaque couche du composant d'écoulement turbulent comprenant de multiples saillies (41a, 42a ; 141a, 142a ; 241a, 242a ; 341a, 342a ; 441a, 442a ; 541a, 542a ; 641a ; 741a) disposées en plusieurs colonnes, chaque colonne de saillies au niveau d'une couche et une colonne correspondante de saillies au niveau d'une couche adjacente étant disposée de manière opposée l'une à l'autre, et les saillies au niveau d'une couche et les saillies correspondantes au niveau de la couche adjacente étant disposées de manière décalée ;
un canal d'écoulement secondaire (42b) étant formé entre les saillies dans chaque colonne, et une direction vers laquelle le canal d'écoulement secondaire (42b) s'étend faisant un angle inclus avec une direction dans laquelle un liquide de refroidissement s'écoule à travers le canal d'écoulement (30) ;
les faces d'extrémité des saillies (441a) dans chaque colonne au niveau d'une couche étant au niveau des faces d'extrémité des saillies (442a) dans la colonne correspondante au niveau de la couche adjacente ; ou les saillies (241a) au niveau d'une couche croisant les saillies (242a) correspondantes au niveau de la couche adjacente ; et
une largeur d'une saillie au niveau d'une couche étant égale à une distance entre des saillies correspondantes au niveau de la couche adjacente.

2. Plaque froide à refroidissement liquide (100, 900) selon la revendication 1, une largeur d'une saillie (441a) dans chaque colonne au niveau d'une couche étant la même qu'une largeur d'une saillie (442a) correspondante dans chaque colonne au niveau de la couche adjacente.

3. Plaque froide à refroidissement liquide (100, 900) selon la revendication 1, une largeur d'une saillie au niveau d'une couche étant supérieure ou inférieure à une largeur d'une saillie correspondante au niveau de la couche adjacente.

4. Plaque froide à refroidissement liquide (100, 900) selon la revendication 1, une section transversale de chaque saillie étant un rectangle, un trapèze ou un triangle.

5. Plaque froide à refroidissement liquide (100, 900) selon l'une quelconque des revendications 1 à 4, chaque saillie étant formée dans le canal d'écoulement (30) par un procédé de traitement en fraisant des rainures, moulant sous pression, soudant ou faisant un dégradé.

6. Plaque froide à refroidissement liquide (100, 900) selon l'une des revendications 1 à 5, une distance existant entre les saillies dans chaque colonne.

7. Plaque froide à refroidissement liquide (100, 900) selon l'une quelconque des revendications 1 à 6, la plaque froide à refroidissement liquide comprenant un substrat supérieur (10) et un substrat inférieur (20), le substrat supérieur (10) et le substrat inférieur (20) étant mutuellement serrés, le canal d'écoulement (30) étant formé entre le substrat supérieur (10) et le substrat inférieur (20), et les saillies (41a, 42a ; 141a, 142a ; 241a, 242a ; 341a, 342a ; 441a, 442a ; 541a, 542a ; 641a ; 741a) étant disposées sur le substrat supérieur (10) et le substrat inférieur (20).
